(19) **Europäisches Patentamt**
**European Patent Office**
**Office européen des brevets**

(11) **EP 3 640 366 B1**

(12) **FASCICULE DE BREVET EUROPEEN**

(45) Date de publication et mention de la délivrance du brevet:
**13.01.2021 Bulletin 2021/02**

(21) Numéro de dépôt: **19202545.0**

(22) Date de dépôt: **10.10.2019**

(51) Int Cl.:
*C23C 14/58* (2006.01)   *C23C 14/06* (2006.01)
*C23C 28/04* (2006.01)   *G02F 1/01* (2006.01)
*G02F 1/15* (2019.01)   *G02B 1/11* (2015.01)
*F24S 70/30* (2018.01)   *F24S 70/225* (2018.01)
*F24S 70/25* (2018.01)   *G02B 1/116* (2015.01)
*F24S 80/00* (2018.01)

(54) **PROCÉDÉ DE FABRICATION D'UN MATÉRIAU MULTICOUCHE THERMORÉGULÉ À BASE DE VO2**

HERSTELLUNGSVERFAHREN EINES MEHRSCHICHTIGEN WÄRMEREGULIERTEN MATERIALS AUF VO2-BASIS

METHOD FOR MANUFACTURING A MULTILAYER THERMOREGULATED MATERIAL MADE OF VO2

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.10.2018 FR 1859555**

(43) Date de publication de la demande:
**22.04.2020 Bulletin 2020/17**

(73) Titulaires:
• **Viessmann Faulquemont**
  **57380 Faulquemont (FR)**
• **Université de Lorraine**
  **54000 Nancy (FR)**
• **Centre National de la Recherche Scientifique**
  **75794 Paris Cedex 16 (FR)**

(72) Inventeurs:
• **CAPON, Fabien**
  **54740 GERMONVILLE (FR)**
• **PILLOUD, David**
  **54000 NANCY (FR)**
• **PIERSON, Jean-François**
  **88450 VINCEY (FR)**

(74) Mandataire: **Cabinet Bleger-Rhein-Poupon**
  **4a rue de l'Industrie**
  **67450 Mundolsheim (FR)**

(56) Documents cités:
**WO-A1-2014/140499**

**Description**

La présente invention entre dans le domaine des matériaux multicouches thermorégulés, en particulier des matériaux multicouches aux propriétés thermochromes utilisables dans la composition d'un panneau solaire.

De manière plus précise, l'invention concerne un procédé amélioré de fabrication d'un matériau multicouche thermorégulé à base de $VO_2$.

Dans la présente demande, on utilisera le principe de conservation de l'énergie totale incidente qui permet de relier la transmittance ou le « coefficient de transmission » ($\tau$), réflectance ou le « coefficient de réflexion » ($\rho$) et absorbance ou le « coefficient d'absorption » ($\alpha$) selon la relation de Kirchhoff. Celle-ci indique qu'à l'équilibre thermique, on peut relier ces coefficients entre eux selon la relation $\tau+\rho+\alpha=1$. Puis on définira, lorsqu'un rayon lumineux incident, c'est-à-dire un flux énergétique $\phi_0$ arrive en contact avec un corps présentant une température T, les grandeurs suivantes :

- La transmittance ou le « coefficient de transmission » : $\tau$
  $\tau= (\phi_t/\phi_0)$; avec $\phi_t$ correspondant au flux énergétique transmis traversant la matière, et $\phi_0$ correspondant au flux énergétique incident apporté par le rayon incident.
  La transmittance dépend de la longueur d'onde $\lambda$ du rayon lumineux incident, de la température, de l'épaisseur et de la composition de la matière ou du corps, elle correspond à la fraction d'énergie issue d'un rayon lumineux capable de traverser la matière ou le corps.

- La réflectance ou le « coefficient de réflexion » : $\rho= (\phi_r/\phi_0)$
  avec $\phi_r$ correspondant au flux énergétique réfléchi sur la surface du matériau, et $\phi_0$ correspondant au flux énergétique incident apporté par le rayon incident. La réflectance $\rho$ correspond à la capacité d'un matériau à réfléchir une onde lumineuse incidente au matériau et peut notamment être influencée par son état de surface et sa rugosité.

- L'absorbance ou le « coefficient d'absorption » : $\alpha$
  L'absorbance d'un matériau dépend de la longueur d'onde $\lambda$ du rayon lumineux incident, de la température, de l'épaisseur et de la composition de la matière dudit matériau, elle correspond à la fraction d'énergie issue d'un rayon lumineux capable d'être absorbée par ledit matériau considéré.

Pour un matériau multicouche fabriqué avec le procédé de la présente demande, on peut également définir les termes suivants :

- L'émissivité $\varepsilon$ :
  L'émissivité d'un matériau traduit sa capacité à émettre un rayonnement par rapport à un corps noir dans les mêmes conditions de température et de longueur d'onde $\lambda$.

Un corps noir est un corps émissif pour lequel l'absorbance $\alpha = 1$ quelle que soit la longueur d'onde $\lambda$.

En outre, à une température d'équilibre donnée et afin de conserver son équilibre thermique, le corps noir réémet toute la puissance qu'il reçoit. La puissance qu'il absorbe est alors égale à la puissance énergétique qu'il émet.

La loi de Kirchhoff précise que pour une température constante et pour une longueur d'onde donnée $\lambda$, l'émissivité $\varepsilon$ d'un matériau à l'équilibre thermique (en le comparant au corps noir de même température) est égale à l'absorbance ($\varepsilon = \alpha$).

Ainsi, pour une longueur d'onde $\lambda$ donnée, l'émissivité $\varepsilon$ peut être définie de la façon suivante : $\varepsilon = 1 - \tau-\rho$, et pour un corps opaque : $\varepsilon = 1 - \rho$.

Un effet thermochrome : ceci correspond à la capacité du matériau, en fonction de sa température T, à présenter une variation réversible de ses propriétés optiques, notamment d'absorption, de transmission, de réflectance ou d'émission d'un rayon lumineux incident. On parle alors de matériau thermochrome ;
« T » représentant la température interne moyenne du matériau ou du corps thermochrome pris en considération.

« $T_{MI}$ » représentant la température de transition métal-isolant du matériau thermochrome considéré, c'est-à-dire la température à laquelle les propriétés électriques et optiques du matériau changent significativement. On choisit de déterminer la valeur de la $T_{MI}$ au centre du cycle d'hystérésis de la courbe de résistance (ou de résistivité électrique) R en Ohm en fonction de la température T en degré Celsius, soit R=f(T).

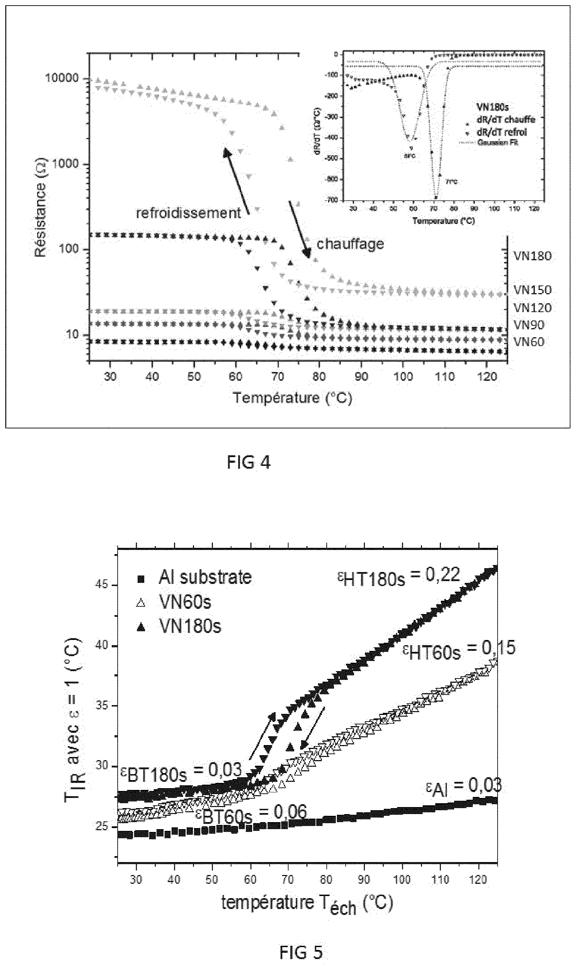

Plus précisément, la $T_{MI}$ correspond à la moyenne du point d'inflexion de ladite courbe (minimum de la dérivée dR/dT) en montée « $T_{MI}$ Mon » = 71 °C et en descente en température « $T_{MI}$ Des » = 58°C, telle que par exemple visible dans le médaillon de la FIG 4.

En d'autres termes, « $T_{MI}$ » correspond à la température « seuil » que va atteindre le matériau et au-delà de laquelle ses propriétés électriques et optiques intrinsèques changent.

Plus spécifiquement, l'invention concerne un procédé amélioré de fabrication d'un matériau multicouche ther-

morégulé à base de $VO_2$. Ce matériau a pour rôle de convertir l'énergie absorbée en énergie calorifique. Cette énergie calorifique est directement exploitable dans un réseau de chaleur, notamment de type eau chaude sanitaire.

L'invention concerne particulièrement un procédé de fabrication d'un matériau multicouche auto adaptatif, thermorégulé à base de $VO_2$ capable d'absorber des rayons lumineux définis par une certaine longueur d'onde $\lambda$, notamment compris entre 250 et 2500 nm correspondant au spectre d'émission solaire.

Ce matériau multicouche à base d'oxyde de vanadium $VO_2$ présente un effet thermochrome. En d'autres termes, le matériau multicouche à base d'oxyde de vanadium $VO_2$ est capable, en fonction de sa température interne moyenne T, de présenter une variation réversible et un changement significatif de ses propriétés électriques et optiques, notamment d'absorption, de transmission, de réflectance ou d'émission d'un rayon lumineux incident ; ceci par rapport à sa température de transition métal isolant $T_{MI}$.

Pour le matériau multicouche thermorégulé à base de $VO_2$ fabriqué par le procédé de l'invention, la $T_{MI}$ est d'environ 64,5°C +/- 10°C, de préférence +/-5°C. °C.

Un tel procédé de fabrication d'un matériau multicouche thermorégulé trouvera une application particulière dans la fabrication de panneaux solaires, en particulier les panneaux solaires thermiques.

De manière connue, le brevet EP 2 976 577 explique comment fabriquer un matériau multicouche thermorégulé à base de $VO_2$.

Plus précisément, EP 2 976 577 précise qu'une couche biphasée de $VO_2$ et de $VnO_{2n+/-1}$ peut être élaborée par pulvérisation cathodique magnétron en condition réactive à partir d'une cible métallique de vanadium, avec ou sans recuit ex-situ de cristallisation, ou par un procédé d'oxydation de revêtements minces de vanadium, ou par un procédé de type sol-gel, ou par tout autre procédé permettant la formation d'un revêtement d'oxyde de vanadium au minimum biphasé, cristallisé, et de composition contrôlée. Dans le cas de la pulvérisation cathodique magnétron en condition réactive, la formation d'une couche $VO_2/VnO_{2n+/-1}$ dépend essentiellement du contrôle précis de la pression partielle d'oxygène dans le réacteur, via le débit d'oxygène $(DO_2)$ introduit, les autres paramètres de dépôt étant constants ; le procédé nécessite généralement la mise en œuvre d'un système optique de régulation du procédé en boucle fermée.

En d'autres termes, le document EP 2 976 577 indique qu'au niveau industriel, on réalise les étapes suivantes :

- dans une enceinte sous vide, on dépose, sur un support ayant une réflectance > à 80% pour des rayonnements de longueur d'onde $\lambda$ > à 5 $\mu$m, par pulvérisation cathodique magnétron en conditions réactives, un film à base de vanadium V, en présence d'un plasma oxygène/argon, de sorte à réaliser l'oxydation du film de vanadium V sous atmosphère contrôlée, afin d'obtenir par la suite une structure cristalline d'oxyde de vanadium $VO_2$ déposée sur ledit support ;

- puis, on recuit, *ex situ,* le matériau obtenu pendant 2 min à 550°C.

Le matériau multicouche thermorégulé à base de $VO_2$ du document EP 2 976 577 présente les propriétés optiques et électriques avec une température de transition métal-isolant $(T_{MI})$ aussi appelée température critique de transition dite « Tc » environs de 68°C, sans que le mode de détermination de cette température soit précisé. Dans la présente invention la terminologie température de transition métal-isolant « $T_{MI}$ » est utilisée.

Toutefois, le procédé de l'art antérieur présente plusieurs désavantages.

En effet, il a été constaté, qu'avec le procédé existant, la cristallisation du film de vanadium V est irrégulière et peut facilement amener à des variations de la composition chimique en oxygène rendant très délicate l'obtention de la couche sélective d'oxyde de vanadium $VO_2$.

En effet, du fait de l'oxydation du film de vanadium à 550°C et par conséquent de la faible stabilité de la couche sélective d"oxyde de vanadium $VO_2$, l'application du procédé connue entraine un fort risque de suroxydation du vanadium diminuant ainsi l'homogénéité de sa composition chimique, et entraine une altération des capacités thermochromes. En outre, pour une durée de recuit *ex-situ* de 150 secondes ou plus, la formation de suroxydes de vanadium, notamment de $V_2O_5$, augmente de manière exponentielle.

En effet, même si le $VO_2$ est détecté après oxydation pour un recuit *ex situ* à l'air allant de 90 à 120 secondes, à partir de 150 secondes de recuit ex -situ, il se forme des phases cristallines stables à 550°C contenant des suroxydes de vanadium, notamment de $V_2O_5$, formant ainsi un matériau multicouche thermorégulé présentant un mélange de phases de différents oxydes qui sont non désirés et gênants. En outre, ce manque d'homogénéité et la présence de suroxydes de vanadium, notamment de $V_2O_5$, altèrent, voire suppriment les capacités thermochromes et par conséquent les propriétés de thermorégulation du matériau multicouche à base de $VO_2$.

En outre, d'un point de vue industriel, des variations de conditions interviennent comme dans toute ligne de fabrication, et sachant que la cristallisation intervient en quelques minutes, il est opportun de mettre en place un procédé de fabrication qui retarde l'apparition de suroxydes de vanadium, notamment de $V_2O_5$. Par conséquent, il est important d'obtenir rapidement la phase ou couche sélective d'oxyde de vanadium $VO_2$ mais aussi de parvenir à la conserver le plus longtemps possible avant que l'opérateur n'observe la formation de suroxydes de vanadium, notamment de $V_2O_5$.

Ainsi, limiter la formation des suroxydes de vanadium permet de garantir la qualité du matériau multicouche thermorégulé à base de $VO_2$ et la fin des rebuts liés à l'étape critique que représente le recuit *ex-situ*. En effet, si on permet une étape de recuit ex situ plus longue, l'ajustement des paramètres de recuit et le contrôle des paramètres en jeu lors du procédé de fabrication du matériau multicouche, on facilitera sa fabrication à un niveau industriel.

Ainsi, dans un but de performance et d'industrialisation du procédé au sein d'une usine de production, il convient de trouver une solution alternative au procédé de fabrication d'un matériau multicouche thermorégulé à base de $VO_2$, qui permette :

- de former rapidement la couche sélective de $VO_2$, tout en évitant le problème de suroxydation, c'est-à-dire la formation de suroxydes de vanadium, notamment ceux de type V205,

- d'augmenter la durée du recuit *ex situ* à l'air (ou de diminuer la température de recuit), pour conduire à des temps de cristallisation retardant ainsi la formation des suroxydes de vanadium, notamment du $V_2O_5$, afin de prévenir sa formation au sein de la couche sélective de $VO_2$ en assurant sa disparition au sein du matériau multicouche ,

- d'obtenir une couche sélective de $VO_2$, stable, de cristallisation uniforme sur le support, de préférence métallique, avec une pureté la plus élevée possible, qui conserve la totalité de ses capacités thermochromes.

La présente invention a pour but de pallier les inconvénients de l'état de la technique, en proposant un procédé de fabrication d'un matériau multicouche thermorégulé à base de d'oxyde de vanadium $VO_2$.
Ledit matériau comprenant au moins un support et une couche sélective à base d'oxyde de vanadium $VO_2$.
Ledit support :

- ayant un coefficient de transmission, sensiblement égal à 0 pour des rayonnements de longueur d'onde $\lambda$ compris entre 0,25 et 25 $\mu$m ;

- ayant un coefficient de réflexion $\rho \geq 0,9$, pour des rayonnements incidents de longueur d'onde $\lambda$ compris entre 7,5 et 10 $\mu$m,

Ladite couche sélective à base d'oxyde de vanadium $VO_2$ ayant une épaisseur comprise entre 50 et 500 nm.
Ledit matériau multicouche thermorégulé obtenu avec le procédé de la présente invention ayant :

- pour des rayonnements de longueur d'onde $\lambda$ comprise entre 0,25 et 2,5 $\mu$m ; un coefficient d'absorption $\alpha \geq 0,8$ ;
- et, pour des rayonnements incidents de longueurs d'onde $\lambda$ comprises entre 7,5 et 10 $\mu$m ; un coefficient de réflexion $\rho$ :
- $\geq 0,85$, lorsque la température T dudit matériau multicouche est inférieure ou égale à la température de transition métal-isolant ($T_{MI}$)en degré Celsius, et compris entre 0,2 et 0,5, lorsque la température T dudit matériau multicouche est supérieure ou égale à la $T_{MI}$ en degré Celsius.

La $TM_I$ correspond à une valeur comprise entre 64,5°C +/- 10°C, de préférence +/- 5°C, dans la présente demande.
De manière spécifique à l'invention, ledit procédé de fabrication dudit matériau multicouche thermorégulé comprend au moins, dans cet ordre, les étapes suivantes:

- On dépose, sur ledit support, par co-pulvérisation cathodique sous vide, en présence d'un plasma réactif constitué d'azote et d'argon, un film de nitrure de vanadium VN d'épaisseur comprise entre 25 et 250 nm, destiné à former ladite couche sélective,

- On recuit « *ex -situ* » sous air à pression atmosphérique le matériau obtenu précédemment à des températures comprises entre 450 et 600°C pendant une durée comprise entre 10 secondes et 30 minutes, de préférence entre 60 et 180 secondes, jusqu'à obtention dudit matériau multicouche thermorégulé à base de $VO_2$.

Dans la présente demande, on entend par le terme « plasma réactif » un plasma constitué d'un mélange d'argon et d'azote. On entend également par « pression atmosphérique » une pression de l'ordre de 1 bar.
L'étape de dépôt à l'aide d'un plasma réactif d'azote et d'argon, permet de former dans le réacteur de dépôt à partir d'une cible métallique de vanadium, un film mince de nitrure de vanadium VN qui constitue le précurseur de réaction. L'étape de recuit « *ex situ* » sous air permet de contrôler avec précision le phénomène d'oxydation, à partir du précurseur VN, et de favoriser l'obtention d'une couche sélective d'oxyde de vanadium $VO_2$ polycristalline, homogène,

exempte de suroxydes de vanadium, notamment $V_2O_5$.

L'utilisation d'un film de nitrure de vanadium VN au lieu d'un film de vanadium V comme précurseur de réaction pour obtenir (lors d'un recuit avec les mêmes conditions de temps et de température) une couche sélective d'oxyde de vanadium $VO_2$ a pour avantage de retarder, voire d'inhiber, le phénomène de formation de suroxyde de vanadium, notamment $V_2O_5$, dans la couche sélective de $VO_2$. Par conséquent, de la même façon que dans l'état de l'art il est possible de former du $VO_2$ mais la phase obtenue est chimiquement plus stable, c'est-à-dire de cristallisation plus homogène, que la phase $VO_2$ formée dans l'art antérieur.

Le recuit ex-situ sous air à pression atmosphérique avec un précurseur de VN permet de stabiliser la phase $VO_2$ et ainsi de s'affranchir des fluctuations et des écarts par rapport aux consignes qui sont inhérentes aux lignes de production industrielle et qui conduisent à une détérioration et à une extraction de la chaine de la couche sélective de $VO_2$ pour une mise au rebut. Dans la présente invention, l'étape de recuit ex situ permet de faciliter la formation d'une couche sélective de $VO_2$ sans formation de suroxydes de vanadium.

De plus, selon d'autres modes de réalisation du procédé de l'invention :

- on dépose un film de nitrure de vanadium VN d'épaisseur comprise entre 25 et 250 nm,

- on recuit *ex situ* à une température comprise entre 450 et 600°C, de préférence 550 °C.

Selon d'autres caractéristiques de l'invention, ledit support consiste en une feuille métallique. Ladite feuille métallique est avantageusement à base d'aluminium Al ou de cuivre Cu, ou encore de matériau non conducteur tels que la silice, le verre ou le silicium. En d'autres termes, ladite feuille métallique comporte avantageusement comme composant majoritaire de l'aluminium Al ou encore du Cuivre Cu, en particulier dans le cadre d'une utilisation du matériau de l'invention pour un panneau solaire.

La présente invention concerne également un panneau solaire comprenant un matériau multicouche thermo-régulé à base de $VO_2$ susceptible d'être obtenu par ledit procédé de fabrication d'un matériau multicouche thermorégulé à base de $VO_2$ de l'invention.

D'autres caractéristiques et avantages de l'invention ressortiront de la description détaillée qui va suivre, en référence aux figures annexées, dans lesquelles :

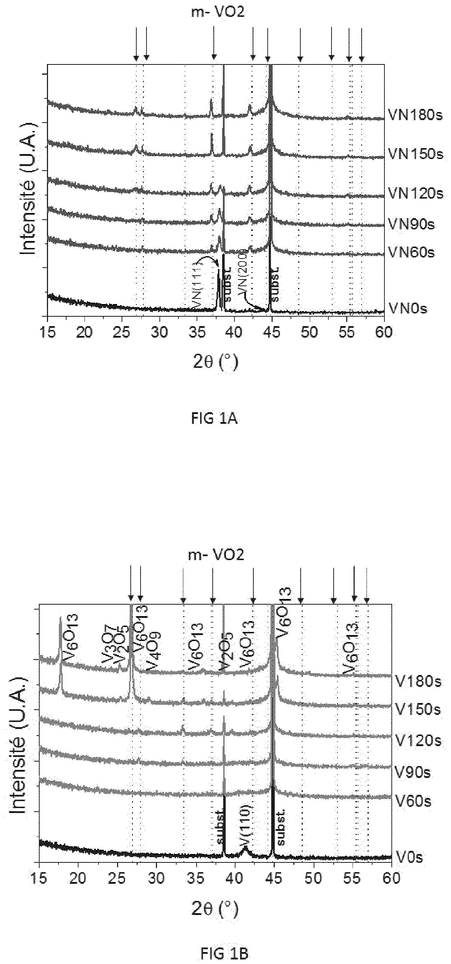

- les figures 1A et 1B représentent le diffractogramme des rayons X d'un film de nitrure de vanadium VN (figure 1A) ou d'un film de vanadium V (figure 1 B) déposé sur un support d'aluminium après recuit *ex situ* à l'air à une température de 550°C pendant une durée allant de 60 à 180 secondes.

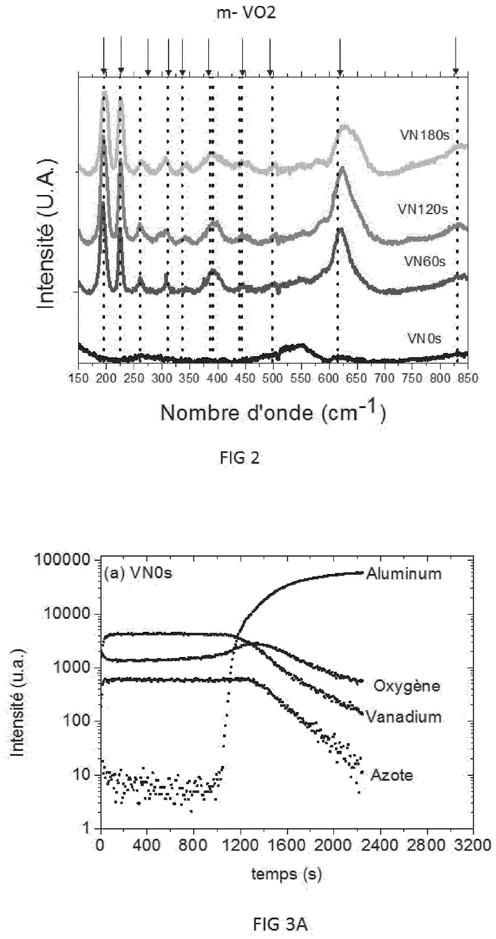

- la figure 2 représente un spectre Raman des films de nitrure de vanadium VN non recuits (VN0) ou après un recuit *ex situ* à l'air à 550°C pendant une durée de 60 (VN60), 120 (VN120) ou 180 (VN180) secondes, suite à un dépôt sur un support d'aluminium,

- Les figures 3A à 3C montrent les profils de concentration en profondeur de l'aluminium, l'oxygène, le vanadium et de l'azote, obtenus par spectrométrie de masse des ions secondaires (SIMS) en fonction du temps, pour des films de VN. déposés sur un support en aluminium, suite à un dépôt sans recuit (VN0) ou avec un recuit à l'air à 550°C pour une durée de 120 secondes (VN120) ou 180 secondes (VN180),

- La figure 4 montre la résistance électrique d'un matériau issu du procédé de l'invention, en fonction de la température des films de VN oxydés après un recuit *ex situ* à l'air à 550°C, pour différentes durées de recuit comprises entre 60 à 180 secondes, suite à un dépôt sur un support de silice,

- La figure 5 montre les mesures par caméra thermique des températures infrarouges apparentes ($T_{IR}$) par rapport à la température T pour l'aluminium (émissivité $\varepsilon$=0,03), et, pour un matériau multicouche obtenu par le procédé de l'invention par dépôt d'un film de nitrure de vanadium VN sur un support d'aluminium et recuit *ex situ* à l'air pendant 60 ou 180 secondes. Les mesures sont effectuées en prenant comme réglage sur la caméra thermique une émissivité $\varepsilon$=1,

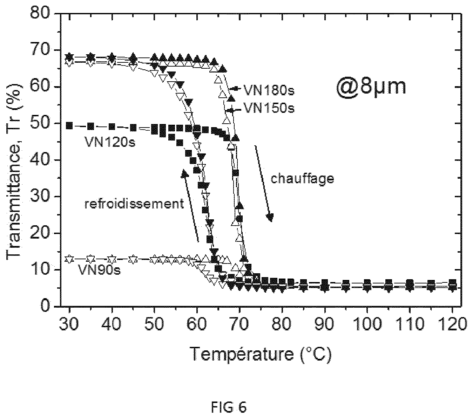

- La figure 6 montre l'évolution de la transmittance infrarouge ($\tau$ %) pour une longueur d'onde de 8 $\mu$m pour un matériau multicouche obtenu avec le procédé de l'invention en fonction de la température, ceci pour un dépôt d'un film de nitrure de vanadium VN sur un support de silicium et une durée de recuit *ex situ* à l'air à 550°C allant de 90 à 180 secondes, pendant le chauffage et le refroidissement.

Les résultats et expériences ci-après montrent l'intérêt d'utiliser comme précurseur le VN dans le procédé de fabrication d'un matériau multicouche thermorégulé à base de $VO_2$ afin d'avoir une couche sélective de $VO_2$, polycris-talline, homogène, sans suroxydation et qui possède l'intégralité des propriétés thermochromes connues de l'art antérieur, notamment pour être utilisable en tant que panneau solaire.

Protocole expérimental :

On réalise le procédé de l'invention. Plus précisément, on dépose, dans une enceinte sous vide, après introduction d'un plasma réactif argon/azote, un film de nitrure de VN ou de vanadium V d'épaisseur comprise entre 25 et 250 nm par pulvérisation cathodique sur un support d'aluminium. On recuit à l'air à 550°C, pendant une durée de 60, 90,120, 150 ou 180 secondes, jusqu'à obtention du matériau multicouche à base de $VO_2$

On analyse le matériau multicouche à base de $VO_2$ obtenu et la qualité de la couche sélective de $VO_2$ obtenue par diffraction des rayons X, par spectrométrie Raman, par mesure de la résistance électrique en fonction de la température (méthode 4 pointes), par spectrométrie de masse des ions secondaires ou encore thermographie infrarouge et spectroscopie à transformée de Fourier en fonction de la température.

Les figures 1A et 1B donnent les diffractogrammes des rayons X pour le dépôt d'un film de nitrure de vanadium VN (figure 1A) par comparaison avec un film de vanadium V (figure 1B). Les oxydes formés ont été analysés par diffraction des rayons X. Plus spécifiquement, les diffractogrammes en mode theta-2theta donnent accès aux pics de diffraction en unité arbitraire (U.A.), en fonction de la durée du recuit *ex situ* en secondes (60, 90,120,150, 180 secondes) et la nature initiale du film déposé (précurseur) VN ou V, ceci pour une température T à 20°C.

Sur les diffractogrammes, les lignes pointillées verticales surmontées par des flèches correspondent aux pics de diffraction de $VO_2$ monoclinique (m-$VO_2$), c'est-à-dire aux pics de diffraction de $VO_2$ quand le matériau multicouche thérmorégulé présente des propriétés semi-conductrices c'est-à-dire que l'on est en dessous de la $T_{MI}$ de 64,5°C. En outre, les pics d'aluminium (subst), les suroxydes de vanadium $V_6O_{13}$, $V_4O_9$, $V_3O_7$ et V205 et le pic de diffraction du nitrure de vanadium VN (VN 111 ou VN 110) sont directement indiqués au-dessus de leurs pics correspondants.

La figure 1B prouve qu'avec un précurseur qui est un film de vanadium V, plusieurs pics typiques des suroxydes de vanadium sont détectés. Ainsi, même si le $VO_2$ est détecté après oxydation par recuit *ex situ* à l'air pendant une durée de 60 à 180 secondes, des suroxydes sont produits au-delà de 150 secondes de recuit *ex situ,* formant un mélange non homogène de phases de différents oxydes. On peut noter aussi que la largeur du pic de diffraction du vanadium V montre que les films bruts de vanadium V sont mal cristallisés. La figure 1B indique que la durée possible de recuit *ex situ* à l'air à 550 °C pour former, sur le support, une couche sélective de $VO_2$ homogène sans suroxyde et aux propriétés thermochromes est très étroite, de 0 à 150 secondes. Ceci rend difficile l'industrialisation du procédé.

Au contraire, la figure 1A montre l'absence de suroxyde de vanadium pour des durées de recuit *ex situ* à l'air à 550 °C allant de 60 à 180 secondes, bien que le $VO_2$ soit détecté. Plus spécifiquement sur la figure 1A, pour un recuit d'une durée de 60 secondes, on constate des pics de $VO_2$ monoclinique (m-$VO_2$) à 27,8°C ; 36,9° ; 42,0° ; 26,9° ou encore 55,4° mais aucun suroxyde de vanadium, en particulier l'absence de $V_2O_5$. Plus spécifiquement, les pics à 26,9° et 55,4° tendent à augmenter avec l'augmentation de la durée de recuit *ex situ,* ce qui signifie que la couche d'oxyde de vanadium $VO_2$ est polycristalline sans texture. Pour une durée de recuit de 150 et 180 secondes, le pic de diffraction du nouveau précurseur, à savoir le nitrure de vanadium VN (VN 111) disparaît complètement au profit des pics de la phase monoclinique de $VO_2$. La taille des grains pour cette phase monoclinique de $VO_2$ (m-$VO_2$), c'est-à-dire pour la couche sélective de $VO_2$ est également homogène, elle est comprise entre 41 et 58 nm quelle que soit la durée du recuit. Ainsi comme la taille de grain est homogène l'homogénéité de la microstructure de la couche sélective de $VO_2$ est encore améliorée.

En conséquence, au contraire du dépôt utilisant comme précurseur un film de vanadium V, le dépôt d'un film de nitrure de vanadium VN, selon le procédé de l'invention permet d'obtenir une couche sélective de $VO_2$ correctement cristallisée dépourvue de suroxyde de vanadium, présentant une taille de grain homogène, même avec une durée de recuit allant jusqu'à 180 secondes.

Pour confirmer la présence d'une couche sélective d'oxyde de vanadium $VO_2$ sans suroxyde de vanadium, en utilisant le procédé de l'invention, on analyse la couche sélective de vanadium $VO_2$ obtenue à partir d'un film de nitrure de vanadium VN selon le procédé de l'invention par spectrométrie Raman. Plus précisément, on réalise le procédé de l'invention en déposant un film de nitrure de vanadium VN d'épaisseur de 110 nm sur un support de silicium et on recuit *ex situ* à l'air, à une température de 550°C pendant une durée de 60, 120 ou 180 secondes, respectivement noté VN 60, VN 120 ou VN 180. Les spectres Raman des couches sélectives $VO_2$ obtenus sont visibles sur la figure 2 qui montre la présence de la phase $VO_2$ mise en évidence par ses modes de vibration en Raman notés en cm-1.

Sur la figure 2, les lignes pointillées verticales surmontées par des flèches m-$VO_2$ correspondent aux modes de vibration Raman de $VO_2$ dans sa structure monoclinique.

Les résultats de la figure 2 du spectre de Raman obtenus confirment que la mise en œuvre du procédé de l'invention permet d'obtenir une couche sélective de $VO_2$ de type monoclinique, qui est un cristal homogène sans présence de suroxyde de vanadium pour toutes les durées de recuit allant de 60 à 180 secondes.

Afin de démontrer la pureté de la couche sélective d'oxyde de vanadium $VO_2$ obtenue avec le procédé de l'invention, on a suivi le profil de concentration atomique en profondeur de la surface de la couche sélective de $VO_2$ jusqu'au support, par la technique de spectrométrie de masse des ions secondaires dite SIMS. Les résultats sont visibles sur les figures 3A à 3C. Ils montrent l'évolution de la stœchiométrie de la surface jusqu'au support d'aluminium, en fonction du temps en secondes, après mise en œuvre du procédé de l'invention sans recuit *ex situ* VN0 ou après un recuit *ex situ* à l'air à 550 °C d'une durée de 120 (VN 120) ou 180 (VN 180) secondes, d'un film de nitrure de vanadium VN déposé sur un support en aluminium.

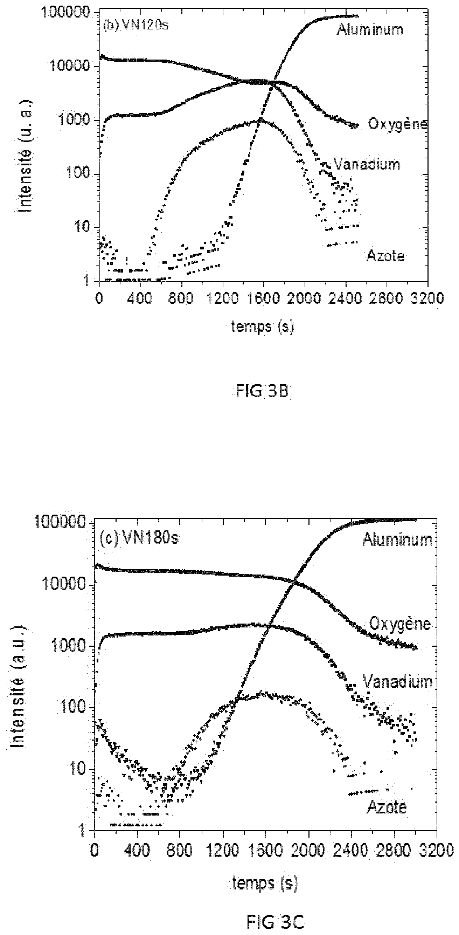

Comme le montre la figure 3B, à 550°C pour une durée de recuit de 120 secondes, la quantité d'azote diminue depuis la surface du film de nitrure de vanadium au profit de l'oxygène de l'air qui diffuse progressivement dans le film de nitrure de vanadium VN pour former la couche sélective de $VO_2$. Ce comportement démontre la diffusion progressive de l'oxygène de l'air dans le film de nitrure de vanadium VN pour former la couche sélective d'oxyde de vanadium $VO_2$ et la diffusion des atomes d'azote hors de ladite couche.

Comme le montre la figure 3C, pour une durée de recuit *ex situ* de 180 secondes, l'intensité du signal, et par conséquent la quantité d'azote N a été considérablement réduite par rapport à une durée de recuit de 120 secondes dans la couche sélective d'oxyde de vanadium $VO_2$. Ces résultats montrent que le nitrure résiduel a complètement disparu et qu'une couche sélective d'oxyde de vanadium $VO_2$ unique, homogène avec un degré de pureté avoisinant les 100% a été formée. En d'autres termes, le procédé de l'invention permet d'obtenir une couche sélective de $VO_2$ présentant un degré de pureté élevé et correctement cristallisé qui contribue à la performance de ses propriétés thermochromes.

Afin de vérifier que le procédé de l'invention donne une couche sélective de $VO_2$ possédant les mêmes propriétés thermochromes que dans l'art antérieur, on a déterminé les températures de transition métal isolant $T_{MI}$ expérimentalement. La $T_{MI}$ a été déterminée à partir des courbes d'évolution ou cycles d'hystérésis de résistance, en fonction de la température, pour plusieurs couches sélectives de $VO_2$ réalisées avec le procédé de l'invention. Les films de nitrure de vanadium VN ont été déposés sur un support électriquement isolant de silice avec une durée de recuit allant de 60 à 180 secondes telle que visible sur la figure 4.

Tels que visible sur la figure 4, les cycles d'hystérésis observés sont des signatures typiques d'un matériau présentant une couche sélective de $VO_2$ thermochrome. Il est constaté également que l'amplitude de la variation de la résistance entre la phase monoclinique semiconductrice (mesuré à 25°C) et la phase métallique (mesurée à 125°C) augmente avec la durée de recuit à l'air. Quelle que soit la durée du recuit, aucune déviation significative des courbes d'hystérésis n'a été observée. En effet, les valeurs de température de transition métal isolant $T_{MI}$ mesurées en montée de température sont stables et proches de 72°C pour une durée de recuit *ex situ* à l'air comprise entre 90 et 180 secondes.

Le tableau 1 ci-dessous regroupe toutes les valeurs calculées pour les matériaux multicouches thermorégulés à base de $VO_2$ obtenus avec le procédé de l'invention pour :

- Un dépôt d'un film de nitrure de vanadium d'épaisseur 110 nm,

- Un support en aluminium,

- Une durée de recuit à l'air : 90, 120, 150 ou 180 secondes.

Les valeurs mesurées sont :

- les températures calculées de transition électrique et optique pour les courbes de chauffage ou montées « $T_{MI}$ Mon » et les courbes de refroidissement ou descentes « $T_{MI}$ Des ». Chaque $T_{MI}$ correspondant au minimum de la dérivée de la courbe de résistance, c'est-à-dire $d(R) / d(T)$,

- la largeur d'hystérésis $\Delta T$, qui est calculée en mesurant la différence des deux valeurs $T_{MI}$ Mon et $T_{MI}$ Des ,

- la transmittance $\tau$ pris pour une longueur d'onde à 2,5 $\mu$m ($\Delta Tr_{2,5}$) et 8 $\mu$m ($\Delta Tr_8$),

- la variation d'émissivité $\Delta\varepsilon$.

Ces valeurs sont récapitulées dans le tableau 1 ci-dessous :

[Tableau 1]

| échantillon | $T_{MI}^{MON}$ (°C) | $T_{MI}^{DES}$ (°C) | Largeur hystérésis (°C) $\Delta T_{MI} = T_c^{MON} - T_c^{DES}$ | $\Delta Tr_{2.5}$ (%) | $\Delta Tr_8$ (%) | $\Delta \varepsilon$ |
|---|---|---|---|---|---|---|
| VN90 | 72.4 | 63.4 | 9.0 | 12.0 | 7.8 | 0.12 |
| VN120 | 72.5 | 63.8 | 9.5 | 43.2 | 42.9 | 0.14 |
| VN150 | 72.6 | 64.1 | 8.5 | 58.4 | 61.3 | 0.18 |
| VN180 | 71.2 | 58.1 | 13.1 | 58.5 | 63.0 | 0.19 |

Ainsi, conformément aux résultats du tableau ci-dessus et aux courbes d'hystérésis de la figure 4, quelle que soit la durée de recuit, les propriétés optiques et électriques, c'est-à-dire son caractère thermochrome, sont conservées avec la mise en œuvre du nouveau procédé de l'invention utilisant comme précurseur de la couche sélective d'oxyde de vanadium $VO_2$ un film de nitrure de vanadium VN. En outre, la variation d'émissivité $\Delta \varepsilon$ existante pour chacun des échantillons testés prouve que le matériau conserve ses propriétés thermochromes et constitue donc un candidat de choix pour être utilisé dans la fabrication d'un panneau solaire.

Le matériau multicouche à base de $VO_2$ obtenu à l'aide du procédé de l'invention est utilisable notamment pour un panneau solaire.

Il convient de vérifier que les propriétés thermochromes de sa couche sélective de $VO_2$ sans suroxyde obtenue à l'aide du procédé de l'invention permettent une régulation thermique passive dans le domaine de l'infrarouge.

La régulation thermique passive est obtenue lorsque l'on a une faible émissivité $\varepsilon$ à une température T en-dessous de la température de transition métal isolant $T_{MI}$, afin de garder la chaleur dans le panneau solaire ; et lorsque l'on constate une forte émissivité $\varepsilon$ à une température T au-dessus de la température de transition métal isolant $T_{MI}$. C'est la variation d'émissivité $\Delta \varepsilon$ positive qui fera que le matériau multicouche thermorégulé à base de $VO_2$ pourra permettre la régulation thermique souhaitée dans un panneau solaire.

La figure 5 montre l'évolution de la température infrarouge d'un matériau multicouche à base de $VO_2$ obtenu avec le procédé de l'invention à partir d'un film de nitrure de vanadium VN recuit ex situ à l'air à 550°C pendant 60 ou 180 secondes après dépôt sur un support d'aluminium, en fonction de la température T dudit matériau pendant le chauffage et le réchauffement.

On constate que la mise en œuvre du procédé de l'invention permet de conserver un matériau multicouche thermorégulé à base de $VO_2$ conservant ses propriétés thermochromes.

De la même manière, la figure 6 montre l'évolution de la transmittance dans le domaine de l'infrarouge à une longueur d'onde de 8 μm en fonction de la température T pour des matériaux multicouches, pendant le chauffage et le refroidissement, obtenus à l'aide du procédé de l'invention. Ces matériaux sont obtenus en déposant un film de nitrure de vanadium VN sur un support de silicium, et en réalisant une durée de recuit ex situ à l'air à 550°C de 90, 120, 150 et 180 secondes. On constate que plus la durée de recuit augmente, plus la transmittance $\tau$ est élevée pour les phases semi-conductrices c'est-à-dire lorsque la température T est inférieure à la $T_{MI}$ d'environ 64,5°C. Ainsi, en utilisant en tant que précurseur un film de nitrure de vanadium VN, il est possible d'augmenter la durée de recuit sans altérer les propriétés thermochromes du matériau multicouche thermorégulé à base de $VO_2$.

Ainsi, au travers des différents résultats d'expérience susmentionnés, on constate que l'utilisation d'un film de nitrure de vanadium pour obtenir un matériau multicouche thermorégulé constitué d'un support avantageusement métallique et d'une couche sélective à base de $VO_2$, possédant les propriétés thermochromes connues de l'art antérieur, est possible. L'augmentation de la durée de recuit ex situ à l'air est avantageuse en cas d'industrialisation du procédé, notamment pour augmenter la marge de manœuvre temporelle pour le contrôle de l'étape recuit.

En outre, grâce au procédé de l'invention entrainant l'élimination de la présence des suroxydes de vanadium, notamment $V_2O_5$, dans la couche sélective de $VO_2$, on augmente la pureté et les capacités optiques et électriques du matériau multicouche.

Ainsi, la présente invention propose un perfectionnement du procédé de fabrication d'un matériau multicouche thermorégulé existant qui permet d'optimiser la pureté de la couche sélective d'oxyde de vanadium, en évacuant le problème de formation de suroxyde, tout en augmentant la durée du recuit ex situ à l'air.

**Revendications**

1. Procédé de fabrication d'un matériau multicouche thermorégulé à base d'oxyde de vanadium $VO_2$, ledit matériau comprenant au moins :

- un support :

• ayant un coefficient de transmission, sensiblement égal à 0 pour des rayonnements de longueur d'onde λ compris entre 0,25 et 25 μm ;
• ayant un coefficient de réflexion ρ ≥ 0,9, pour des rayonnements incidents de longueur d'onde λ compris entre 7,5 et 10 μm,

- une couche sélective à base de $VO_2$ ayant une épaisseur comprise entre 50 et 500 nm,
ledit matériau multicouche thermorégulé ayant :

• pour des rayonnements de longueur d'onde λ comprise entre 0,25 et 2,5 μm ; un coefficient d'absorption α ≥ 0,8 ;
• et, pour des rayonnements incidents de longueurs d'onde λ comprises entre 7,5 et 10 μm ; un coefficient de réflexion ρ :

∘ ≥ 0,85, lorsque la température T dudit matériau multicouche est ≤ à la température de transition métal isolant dit « $T_{MI}$ »,
"$T_{MI}$" étant déterminée pour un matériau considéré selon la méthode définie dans la description;
∘ compris entre 0,2 et 0,5, lorsque la température T dudit matériau multicouche est ≥ à la température de transition métal isolant dit « $T_{MI}$ » ;

**caractérisé en ce que** ledit procédé de fabrication dudit matériau multicouche thermorégulé comprend au moins, dans cet ordre, les étapes suivantes:

- On dépose, sur ledit support, par co-pulvérisation cathodique sous vide, en présence d'un plasma réactif constitué d'azote et d'argon, un film de nitrure de vanadium VN d'épaisseur comprise entre 25 et 250 nm, destinée à former ladite couche sélective,
- On recuit *ex situ,* sous air à pression atmosphérique, le matériau obtenu précédemment à des températures comprises entre 450 et 600°C, pendant une durée comprise entre 10 secondes et 30 minutes, de préférence entre 60 et 180 secondes, jusqu'à obtention dudit matériau multicouche thermorégulé de $VO_2$.

2. Procédé de fabrication d'un matériau multicouche thermorégulé à base de V02, selon la revendication précédente, dans lequel la température de transition métal -isolant dit « TMI » consiste en une valeur comprise entre 64,5°C +/- 10°C, de préférence +/- 5°C.

3. Procédé de fabrication d'un matériau multicouche thermorégulé à base de $VO_2$, selon l'une quelconque des revendications précédentes, dans lequel ledit support consiste en une feuille métallique.

4. Procédé de fabrication d'un matériau multicouche thermorégulé à base de $VO_2$, selon la revendication précédente, **caractérisé en ce que** ladite feuille métallique est à base d'aluminium Al ou en cuivre Cu.


**Patentansprüche**

1. Verfahren zur Herstellung eines thermisch regulierten Mehrschichtmaterials auf der Basis von Vanadiumoxid $VO_2$, wobei das Material mindestens umfasst:

- einen Träger:

• mit einem Transmissionskoeffizienten von etwa gleich 0 für Strahlen mit einer Wellenlänge λ zwischen 0,25 und 25 μm;
• mit einem Reflexionskoeffizienten ρ ≥ 0,9 für einfallende Strahlen mit einer Wellenlänge λ zwischen 7,5 und 10 μm,

- eine selektive Schicht auf der Basis von $VO_2$ mit einer Dicke zwischen 50 und 500 nm,
wobei das thermisch regulierte Mehrschichtmaterial hat:

• für Strahlen mit einer Wellenlänge λ zwischen 0,25 und 2,5 μm einen Absorptionskoeffizienten α ≥ 0,8;

• und für einfallende Strahlen mit einer Wellenlänge $\lambda$ zwischen 7,5 und 10 $\mu$m einen Reflexionskoeffizienten p:

◦ $\geq$ 0,85, wenn die Temperatur T des Mehrschichtmaterials $\leq$ als die Metall-Isolierung-Übergangstemperatur "$T_{MI}$" ist,
◦ zwischen 0,2 und 0,5, wenn die Temperatur T des Mehrschichtmaterials $\geq$ als die Metall-Isolierung-Übergangstemperatur "$T_{MI}$" ist;

**dadurch gekennzeichnet, dass** das Verfahren zur Herstellung des thermisch regulierten Mehrschichtmaterials mindestens, in dieser Reihenfolge, die folgenden Schritte umfasst:

- Aufbringen, auf den Träger, durch Vakuum-Kathodenzerstäubung, bei Anwesenheit eines Reaktionsplasmas, bestehend aus Stickstoff und Argon, eines Vanadiumnitridfilms VN in einer Dicke zwischen 25 und 250 nm, der bestimmt ist, die selektive Schicht zu bilden,
- Tempern, *ex situ,* in der Luft unter atmosphärischem Druck, des zuvor erhaltenen Materials bei Temperaturen zwischen 450 und 600 °C während einer Dauer zwischen 10 Sekunden und 30 Minuten, vorzugsweise zwischen 60 und 180 Sekunden, bis zum Erhalt des thermisch regulierten $VO_2$-Mehrschichtmaterials.

2. Verfahren zur Herstellung eines thermisch regulierten Mehrschichtmaterials auf der Basis von $VO_2$ nach vorangehendem Anspruch, wobei die Metall-Isolierung-Übergangstemperatur "$T_{MI}$" in einem Wert besteht, der zwischen 64,5 °C +/- 10 °C, vorzugsweise +/- 5 °C, liegt.

3. Verfahren zur Herstellung eines thermisch regulierten Mehrschichtmaterials auf der Basis von $VO_2$ nach einem der vorangehenden Ansprüche, wobei der Träger aus einer Metallfolie besteht.

4. Verfahren zur Herstellung eines thermisch regulierten Mehrschichtmaterials auf der Basis von $VO_2$ nach vorangehendem Anspruch, **dadurch gekennzeichnet, dass** die Metallfolie auf der Basis von Aluminium Al oder aus Kupfer Cu ist.

**Claims**

1. Process for manufacturing a thermoregulated multilayer material containing vanadium oxide V02, said material comprising at least:

- a substrate:

• having a transmission coefficient substantially equal to 0 for radiation of wavelength $\lambda$ between 0.25 and 25 $\mu$m;
• having a reflection coefficient $\rho \geq 0.9$, for incident radiation of wavelength $\lambda$ between 7.5 and 10 $\mu$m,

- a selective $VO_2$ layer of thickness between 50 and 500 nm,
said thermoregulated multilayer material having:

• for radiation of wavelength $\lambda$ between 0.25 and 2.5 $\mu$m: an absorption coefficient $\alpha \geq 0.8$;
• and for incident radiation of wavelength $\lambda$ between 7.5 and 10 $\mu$m: a reflection coefficient p:

◦ $\geq$ 0.85, when the temperature T of said multilayer material is $\leq$ the metal-insulator transition temperature denoted « $T_{MI}$ »,
◦ between 0.2 and 0.5, when the temperature T of said multilayer material is $\geq$ the metal-insulator transition temperature denoted « $T_{MI}$ »,

**characterized in that** said manufacturing process of said thermoregulated multilayer material comprises, in this order, at least the following steps:

- On said substrate, via vacuum cathodic co-sputtering in the presence of a reactive plasma composed of nitrogen and argon, a film of vanadium nitride VN is deposited of thickness between 25 and 250 nm, intended to form said selective layer;

- Under air at atmospheric pressure, the previously obtained material is annealed *ex situ* at temperatures between 450 and 600 °C, for a time of between 10 seconds and 30 minutes, preferably between 60 and 180 seconds, until said $VO_2$ thermoregulated multilayer material is obtained.

2. The process for manufacturing a $VO_2$ thermoregulated multilayer material according to the preceding claim, wherein the metal-insulator transition temperature denoted « TMI » is a value of between 64.5°C +/- 10°C, preferably +/-5°C.

3. The process for manufacturing a $VO_2$ thermoregulated multilayer material according to any of the preceding claims, wherein said substrate is a metal foil.

4. The process for manufacturing a $VO_2$ thermoregulated multilayer material according to the preceding claim, **characterized in that** said metal foil is an aluminium Al or copper Cu foil.

FIG 1A

FIG 1B

m- VO2

FIG 2

FIG 3A

FIG 3B

FIG 3C

FIG 4

FIG 5

FIG 6

**RÉFÉRENCES CITÉES DANS LA DESCRIPTION**

**Documents brevets cités dans la description**

- EP 2976577 A